Europäisches Patentamt

European Patent Office

Office européen des brevets

(19)

(11) EP 0 868 027 B1

(12) **EUROPÄISCHE PATENTSCHRIFT**

(45) Veröffentlichungstag und Bekanntmachung des Hinweises auf die Patenterteilung:
**24.10.2001 Patentblatt 2001/43**

(51) Int Cl.7: **H03K 5/13**, H03K 5/15

(21) Anmeldenummer: **98104029.8**

(22) Anmeldetag: **06.03.1998**

(54) **Schaltung zur Taktsignalverzögerung mit Messung der Verzögerungszeit**

Delay circuit for a clock signal with delay measurement

Circuit de retard pour un signal d'horloge avec mesure de retard

(84) Benannte Vertragsstaaten:
**DE FR GB IT**

(30) Priorität: **27.03.1997 DE 19713130**

(43) Veröffentlichungstag der Anmeldung:
**30.09.1998 Patentblatt 1998/40**

(73) Patentinhaber: **Endress + Hauser GmbH + Co.**
**79689 Maulburg (DE)**

(72) Erfinder: **Schmidt, Hartmut**
**79576 Weil am Rhein (DE)**

(74) Vertreter: **Schwepfinger, Karl-Heinz, Dipl.-Ing.**
**Prinz & Partner GbR**
**Manzingerweg 7**
**81241 München (DE)**

(56) Entgegenhaltungen:
**EP-A- 0 379 169          US-A- 5 548 237**

- '**ELECTROMAGNETIC INTERFERENCE REDUCTION THROUGH TIME DISTRIBUTION OF CLOCK SIGNALS' IBM TECHNICAL DISCLOSURE BULLETIN** Bd. 37, Nr. 7, 01 Juli 1994, Seiten 165 - 168, XP000455474 ISSN: 0018-8689

**Beschreibung**

Die Erfindung betrifft eine Schaltungsanordnung zum Erzeugen zweier zeitlich gegeneinander verschobener Signale aus einem Taktsignal und zum Erzeugen eines von der Zeitverschiebung zwischen den beiden Signalen abhängigen Meßsignals, mit einem Eingang, an dem das Taktsignal anliegt, einem ersten Ausgang, an dem ein aus dem Taktsignal erzeugtes unverzögertes Signal abgegeben wird, einem zweiten Ausgang, an dem ein aus dem Taktsignal erzeugtes und gegenüber dem unverzögerten Signal verzögertes Signal abgegeben wird, einem zwischen den Eingang der Schaltungsanordnung und den ersten Ausgang der Schaltungsanordnung eingefügten Inverter und mit einem NAND-Gatter, das an einem Eingang das verzögerte Signal und an dem anderen Eingang das Ausgangssignal des Inverters empfängt und das von der Zeitverschiebung zwischen dem unverzögerten Signal und dem verzögerten Signal abhängige Meßsignal abgibt. Eine derartige Schattungsanordnung ist aus EP-A-0 379 169 bekannt.

Bei einer Schaltungsanordnung dieser Art ist der Inverter, der das zur Erzeugung des unverzögerten Signals dienende Taktsignal invertiert, deshalb erforderlich, weil das NAND-Gatter nur dann ein zur Messung der Zeitverschiebung zwischen den beiden Signalen geeignetes Meßsignal erzeugt, wenn eines der beiden dem NAND-Gatter zugeführten Signale invertiert ist. Damit jedoch das unverzögerte Signal gegenüber dem verzögerten Signal nicht invertiert ist, ist bei bekannten Schaltungsanordnungen dieser Art dem Inverter ein zweiter Inverter nachgeschaltet, der die Invertierung des unverzögerten Signals wieder rückgängig macht. Dadurch entsteht jedoch das Problem, daß die aus dem Meßsignal bestimmte Zeitverschiebung nicht mit der tatsächlichen Zeitverschiebung zwischen den an den beiden Ausgängen der Schaltungsanordnung abgegebenen Signalen übereinstimmt. Dies liegt daran, daß jeder Inverter eine innere Eigenverzögerung aufweist, die dem zu invertierenden Signal erteilt wird, daß aber die vom zweiten Inverter erteilte Eigenverzögerung vom NAND-Gatter nicht erfaßt wird, weil der zweite Inverter hinter dem Schaltungspunkt angeschlossen ist, an dem das invertierte Taktsignal zum NAND-Gatter abgezweigt wird. Deshalb besteht über die tatsächliche Zeitverschiebung zwischen den beiden an den Ausgängen der Schaltungsanordnung auftretenden Signalen eine Unsicherheit, die mit der bekannten Schaltungsanordnung nicht zu beseitigen ist. Dieser Nachteil wiegt dann besonders schwer, wenn extrem kleine und genau definierte Zeitverschiebungen zwischen den beiden Signalen erzielt werden sollen.

Die Aufgabe der Erfindung besteht darin, eine Schaltungsanordnung der eingangs angegebenen Art zu schaffen, mit der die tatsächliche Zeitverschiebung zwischen den an den beiden Ausgängen der Schaltungsanordnung abgegebenen Signalen genau bestimmt werden kann.

Zur Lösung dieser Aufgabe ist bei der erfindungsgemäßen Schaltungsanordnung nur ein Inverter vorhanden, der ein steuerbarer Inverter ist, der durch ein Schaltsignal zwischen einem invertierenden und einem nichtinvertierenden Zustand umschaltbar ist.

Der bei der Erfindung verwendete steuerbare Inverter macht den bisher verwendeten zweiten Inverter, dessen Eigenverzögerung nicht in die Messung eingeht, überflüssig. Durch das an einen Eingang des steuerbaren Inverters angelegte binäre Schaltsignal wird die Schaltungsanordnung zwischen einer Nutzphase und einer Meßphase umgeschaltet. In der Meßphase übernimmt der steuerbare Inverter die für die Meßfunktion des NAND-Gatters erforderliche Aufgabe des Invertierens des am Eingang der Schaltungsanordnung anliegenden Taktsignals, während in der Nutzphase dieses Signal ohne Invertierung durch den steuerbaren Inverter hindurchläuft, so daß es als unverzögertes Signal zusammen mit dem verzögerten Signal genutzt werden kann. In beiden Phasen läuft also das am Eingang der Schaltungsanordnung anliegende Taktsignal vor dem Erreichen des ersten Ausgangs der Schaltungsanordnung durch den steuerbaren Inverter, der in beiden Phasen dem Taktsignal die gleiche Eigenverzögerung erteilt. Somit liefert das NAND-Gatter in jeder Meßphase ein Meßsignal, das der tatsächlichen Zeitverschiebung zwischen den in jeder Nutzphase an den beiden Ausgängen der Schaltungsordnung abgegebenen Signalen entspricht und die Verzögerungen sämtlicher aktiven Bauelemente berücksichtigt, die vor dem Erreichen der beiden Ausgänge der Schaltungsanordnung von den beiden Signalen durchlaufen werden.

Vorteilhafte Ausgestaltungen und Weiterbildungen der Erfindung sind in den abhängigen Ansprüchen gekennzeichnet.

Weitere Merkmale und Vorteile der Erfindung ergeben sich aus der folgenden Beschreibung eines Ausführungsbeispiels an Hand der Zeichnungen. In den Zeichnungen zeigen:

Fig. 1      ein Ausführungsbeispiel der erfindungsgemäßen Schaltungsanordnung zum Erzeugen zweier zeitlich gegeneinander verschobener Signale aus einem Taktsignal und zum Erzeugen eines von der Zeitverschiebung zwischen den beiden Signalen abhängigen Meßsignals,

Fig. 2      vier Signaldiagramme zur Erläuterung der Funktionsweise der in Fig. 1 dargestellten Schaltungsanordnung und

Fig. 3      eine Wahrheitstabelle zur Erläuterung der Übertragungsfunktion des XOR-Gatters, das bei der Schaltungsanordnung von Fig. 1 als steuerbarer Inverter verwendet wird.

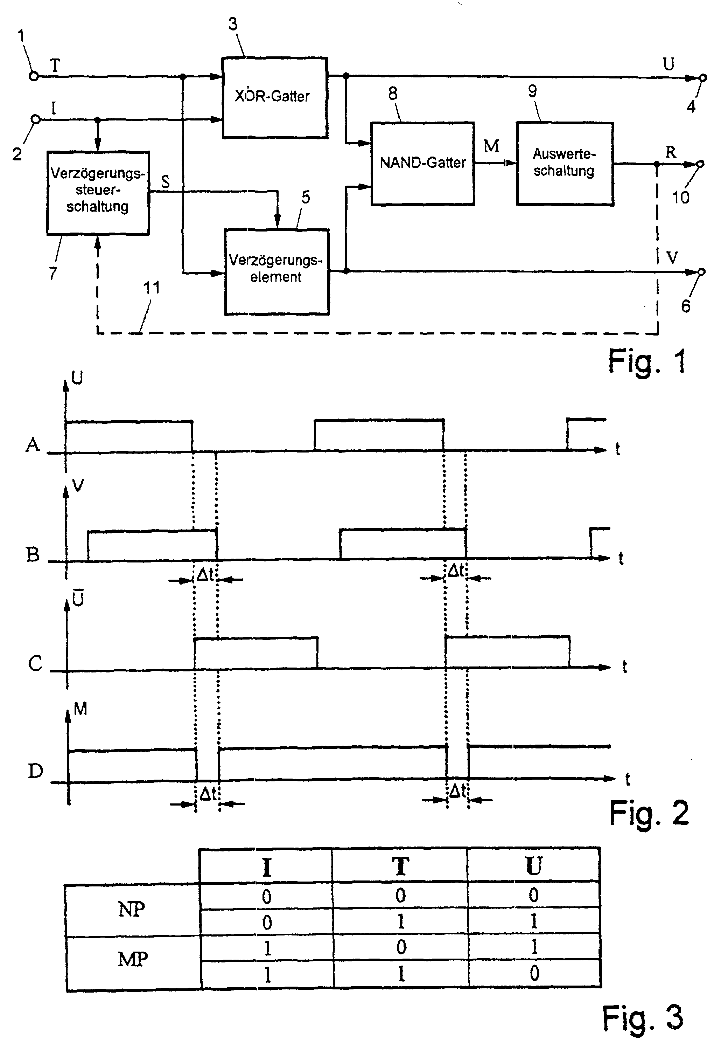

Die in Fig. 1 dargestellte Schaltungsanordnung hat einen ersten Eingang 1, dem ein Taktsignal T mit einer bestimmten Taktfrequenz zugeführt wird, und einen zweiten Eingang 2, dem ein binäres Schaltsignal I zugeführt wird.Der erste Eingang 1 der Schaltungsanordnung ist mit dem ersten Eingang eines XOR-Gatters 3 verbunden, und der zweite Eingang der Schaltungsanordnung ist mit dem zweiten Eingang des XOR-Gatters 3 verbunden. Der Ausgang des XOR-Gatters ist mit einem ersten Ausgang 4 der Schaltungsanordnung verbunden. Das XOR-Gatter 3 bildet einen durch das Schaltsignal I steuerbaren Inverter für das Taktsignal T, der zwischen den Zuständen "invertierend" (für I = 1) und "nichtinvertierend" (für I = 0) umgeschaltet werden kann. Das XOR-Gatter 3 verursacht eine innere Eigenverzögerung geringer Größe, die nicht von dem logischen Wert des Schaltsignals I abhängt, so daß das Taktsignal T für I = 0 die gleiche Zeit wie für I = 1 benötigt, um das XOR-Gatter 3 zu durchlaufen. Das Taktsignal T wird von der Verbindung zwischen dem ersten Eingang 1 und dem XOR-Gatter 3 in einen zweiten Schaltungszweig abgeleitet, in dem es einem Verzögerungselement 5 zugeführt wird, über das es in verzögerter Form zu einem zweiten Ausgang 6 der Schaltungsanordnung gelangt. Die vom Verzögerungselement 5 verursachte Verzögerung ist durch ein Steuersignal S einstellbar, das dem Verzögerungselement 5 von einer Verzögerungssteuerschaltung 7 zugeführt wird. Diese Verzögerung ist größer als die vom XOR-Gatter 3 verursachte innere Eigenverzögerung, so daß das Ausgangssignal des Verzögerungselements 5 gegenüber dem Ausgangssignal des XOR-Gatters 3 um eine Verzögerungszeit $\Delta t$ verzögert ist. In der folgenden Beschreibung wird das am ersten Ausgang 4 der Schaltungsanordnung auftretende Signal als das unverzögerte Signal U und das am zweiten Ausgang 6 der Schaltungsanordnung auftretende Signal als das verzögerte Signal V bezeichnet. Somit sind die von dem gleichen Taktsignal T abgeleiteten Signale U und V gegeneinander zeitlich verschoben, und ihre Zeitverschiebung ist gleich der Verzögerungszeit $\Delta t$.

Zur Messung der zwischen den Signalen U und V bestehenden zeitlichen Verschiebung ist ein NAND-Gatter 8 vorgesehen, dessen einer Eingang mit dem Ausgang des XOR-Gatters 3 verbunden ist und dessen anderer Eingang mit dem Ausgang des Verzögerungselements 5 verbunden ist. Das Ausgangssignal M des NAND-Gatters 8 wird einer Auswerteschaltung 9 zugeführt, die ein Ausgangssignal R liefert, das einem Meßausgang 10 der Schaltungsanordnung zugeführt wird. Im folgenden wird die Arbeitsweise der in Figur 1 dargestellten Schaltungsanordnung anhand der Figuren 2 und 3 erläutert.

Die Schaltungsanordnung wird in zwei sich gegenseitig ausschließenden Phasen betrieben, nämlich einer Nutzphase NP und einer Meßphase MP. Die Nutzphase NP wird dadurch bestimmt, daß das am zweiten Eingang des XOR-Gatters 3 anliegende binäre Schaltsignal I den logischen Wert 0 hat, so daß das XOR-Gatter 3 im nichtinvertierenden Zustand ist. Wie in der Wahrheitstabelle von Figur 3 zu erkennen ist, läßt das XOR-Gatter 3 dann das Taktsignal T ohne Invertierung seines logischen Zustands zum ersten Ausgang 4 der Schaltungsanordnung durch. Das Signaldiagramm A von Figur 2 zeigt das unverzögerte Signal U, das in der Nutzphase NP am ersten Ausgang 4 der Schaltungsanordnung abgegeben wird. Dieses Signal entspricht dem Taktsignal T, abgesehen von der geringfügigen Verzögerung, die durch die innere Eigenverzögerung des XOR-Gatters 3 verursacht wird. Bei dem dargestellten Beispiel besteht das Taktsignal T und somit auch das Signal U aus Rechteckimpulsen, die durch Pausen voneinander getrennt sind, die die gleiche Dauer wie die Impulse haben.

Das Signaldiagramm B von Figur 2 zeigt das Signal V, das sowohl in der Nutzphase NP als auch in der Meßphase MP am zweiten Ausgang 6 der Schaltungsanordnung anliegt. Auch dieses Signal hat die Form des Taktsignals T, es ist aber gegenüber dem Signal U um die Verzögerungszeit $\Delta t$ verschoben, die ihm vom Verzögerungselement 5 erteilt wird, so daß die folgende Gleichung gilt:

$$V(t) = U(t-\Delta t) \qquad (1)$$

In der Nutzphase NP kann das am ersten Ausgang 4 der Schaltungsanordnung auftretende unverzögerte Signal U zusammen mit dem am zweiten Ausgang 6 der Schaltungsanordnung auftretenden verzögerten Signal V genutzt werden. So können zum Beispiel die Flanken der beiden Signale U und V dazu verwendet werden, Vorgänge auszulösen, die in einem gewünschten Zeitabstand voneinander beginnen sollen. Zu diesem Zweck muß die Zeitverschiebung $\Delta t$ zwischen den Signalen U und V genau bekannt sein, und, falls notwendig, korrigiert werden. In der Schaltungsanordnung von Figur 1 ist die Zeitverschiebung $\Delta t$ in erster Linie durch das Verzögerungssteuersignal S bestimmt, durch das von der Verzögerungssteuerschaltung 7 im Verzögerungselement 5 ein Sollwert $\Delta t_s$ für die Zeitverzögerung eingestellt wird. Dieser Sollwert berücksichtigt natürlich auch die innere Eigenverzögerung des XOR-Gatters 3. Die sich tatsächlich zwischen den Signalen U und V ergebende Zeitverschiebung $\Delta t$ stimmt jedoch infolge von Parameterstreuungen der Bauelemente, Temperaturänderungen und anderen Einflüssen in der Regel nicht mit dem eingestellten Sollwert $\Delta t_s$ überein. Außerdem kann es sein, daß der Zusammenhang zwischen dem Verzögerungssteuersignal S und der im Verzögerungselement 5 eingestellten Verzögerungszeit nicht linear ist oder nicht genau bekannt ist. Alle diese zusätzlichen Einflüsse können in einem Term $\Delta t_a$ zusammengefaßt werden, der die Abweichung zwischen dem Sollwert $\Delta t_s$ und der tatsächlichen Zeitverschiebung $\Delta t$ zwischen den Signalen U und V beschreibt. Es gilt also:

$$\Delta t = \Delta t_s \pm \Delta t_a \qquad (2)$$

In der Schaltungsanordnung von Figur 1 wird die Zeitverschiebung Δt zwischen den Signalen U und V mit Hilfe des NAND-Gatters 8 ermittelt. In den Nutzphasen NP ist jedoch die Ermittlung der Zeitverschiebung Δt mit Hilfe des NAND-Gatters nicht möglich, weil das NAND-Gatter 8 ein die Zeitverschiebung zwischen dem unverzögerten Signal U und dem verzögerten Signal V anzeigendes Signal nur dann liefert, wenn eines der beiden Signale in invertierter Form vorliegt, was in den Nutzphasen NP nicht der Fall ist.

Daher werden zur Bestimmung der Zeitverschiebung Δt, die in den Nutzphasen NP zwischen den Signalen U und V besteht, die Meßphasen MP eingeführt, die dadurch bestimmt sind, daß das am XOR-Gatter 3 anliegende binäre Schaltsignal I den logischen Wert 1 hat, so daß sich das XOR-Gatter 3 im invertierenden Zustand befindet. Wie in der Wahrheitstabelle von Figur 3 zu erkennen ist, wirkt dann das XOR-Gatter 3 für das vom Eingang 1 kommende Taktsignal T als Inverter. Das invertierte Ausgangssignal $\overline{U}$ des XOR-Gatters 3 ist im Signaldiagramm C von Fig. 2 dargestellt. Dieses invertierte Ausgangssignal $\overline{U}$ ist mit der gleichen Eigenverzögerung des XOR-Gatters 3 behaftet wie das nichtinvertierte Signal U in den Nutzphasen NP.

In jeder Meßphase MP empfängt das NAND-Gatter 8 am einen Eingang das verzögerte Signal V und am anderen Eingang das invertierte unverzögerte Signal $\overline{U}$. Das Signaldiagramm D von Figur 2 zeigt das vom NAND-Gatters 8 in jeder Meßphase MP abgegebene Meßsignal M. Die gesuchte Zeitverschiebung Δt ergibt sich aus den Signallücken im Signal M, wobei die Dauer jeder Signallücke gleich der Zeitverschiebung Δt ist, die in den Nutzphasen NP zwischen dem Signal V und dem nichtinvertierten Signal $\underline{U}$ besteht. Es ist auch zu erkennen, daß das NAND-Gatter 8 nur dann ein nutzbares Meßsignal M liefert, wenn die Zeitverschiebung zwischen den beiden Signalen U und V kleiner als die Dauer eines Taktimpulses ist.

Das vom NAND-Gatter 8 gelieferte Meßsignal M wird der Auswerteschaltung 9 zugeführt, die aus dem Meßsignal M ein Ausgangssignal R erzeugt, das der Dauer der Signallücken im Meßsignal M und somit auch der Zeitverschiebung Δt proportional ist, die in den Nutzphasen NP zwischen den an den beiden Ausgängen 4 und 6 der Schaltungsanordnung auftretenden Signalen U und V besteht. Dies kann beispielsweise dadurch erreicht werden, daß die Auswerteschaltung 9 das Meßsignal M invertiert und das invertierte Meßsignal anschließend integriert. Das Ausgangssignal R der Auswerteschaltung 9 ist in jeder Meßphase MP an dem Meßausgang 10 der Schaltungsanordnung verfügbar.

Das Ausgangssignal R der Auswerteschaltung 9 kann auch der Verzögerungssteuerschaltung 7 zugeführt werden, wie durch die gestrichelte Linie 11 vom Ausgang der Auswerteschaltung zur Verzögerungssteuerschaltung 7 in Figur 1 angezeigt ist. Dadurch kann das Verzögerungssteuersignal S so korrigiert werden, daß eine gewünschte Zeitverschiebung Δt erreicht wird. In diesem Fall bilden das NAND-Gatter 8, die Auswerteschaltung 9, die Verzögerungssteuerschaltung 7 und das Verzögerungselement 5 einen Regelkreis, der dazu dient, Abweichungen von der gewünschten Zeitverschiebung automatisch zu korrigieren. Das Ausgangssignal R der Auswerteschaltung 9 kann allerdings nur in den Meßphasen MP zur Korrektur verwendet werden, da es in den Nutzphasen NP kein Maß für die Zeitverschiebung darstellt. Deshalb wird die Verzögerungssteuerschaltung 7 in diesem Fall zusätzlich durch das Schaltsignal I gesteuert, das zwischen den Meßphasen MP und den Nutzphasen NP umschaltet, wie in Figur 1 durch den vom Eingang 2 zur Verzögerungssteuerschaltung 7 gerichteten Pfeil angedeutet ist. Wenn das Schaltsignal I den logischen Wert 1 hat, der die Meßphasen MP bestimmt, gibt es die Korrektur der durch das Steuersignal S bestimmten Verzögerungszeit frei, so daß die Verzögerungszeit den gewünschten Wert erhält, der dann durch das Steuersignal S auch in den Nutzphasen NP aufrechterhalten wird. Wenn das Schaltsignal S den logischen Wert 0 hat, der die Nutzphasen NP bestimmt, sperrt es den Korrektureinfluß des Ausgangssignals R der Auswerteschaltung 9 auf das Steuersignal S, das dann den in der vorangehenden Meßphase MP festgelegten Sollwert beibehält.

Die Umschaltung zwischen den Nutzphasen NP und den Meßphasen MP kann in Zeitabständen erfolgen, die so gewählt sind, daß die Meßphasen MP nicht die Verwendung der Signale U und V in der Nutzphasen NP beeinträchtigen.

Die beschriebene Schaltungsanordnung kann die beschriebene Funktion auch dann erfüllen, wenn ein invertierendes Verzögerungselement 5 verwendet wird. Dann muß nur die Zuordnung der logischen Werte des Schaltsignals I zu den beiden Phasen NP und MP umgekehrt werden, so daß dann in jeder Nutzphase NP ein Schaltsignal mit dem logischen Wert 1 und in jeder Meßphase MP ein Schaltsignal mit dem logischen Wert 0 angelegt wird.

Das XOR-Gatter 3 kann durch einen beliebigen anderen steuerbaren Inverter ersetzt werden, der durch ein Schaltsignal zwischen einem invertierenden Zustand und einem nichtinvertierenden Zustand umschaltbar ist und bei dem die Eigenverzögerung, die dem Taktsignal beim Durchlaufen des Inverters erteilt wird, in beiden Zuständen gleich ist.

**Patentansprüche**

1. Schaltungsanordnung zum Erzeugen zweier zeitlich gegeneinander verschobener Signale (U, V) aus einem Taktsignal (T) und zum Erzeugen eines von der Zeitverschiebung (Δt) zwischen den beiden Signalen (U, V) abhängigen Meßsignals (M), mit einem Eingang (1), an dem das Taktsignal (1) anliegt, einem ersten Ausgang (4), an dem ein aus dem Taktsignal (T) erzeugtes unverzögertes Signal (U) abgegeben wird, einem zweiten Ausgang (6), an dem ein aus dem Taktsignal (T) erzeugtes und gegenüber dem unverzögerten Signal (U) verzögertes Signal (V) abgegeben wird, einem zwischen den Eingang (1) der Schaltungsanordnung und den ersten Ausgang (6) der Schaltungsanordnung eingefügten Inverter (3) und mit einem NAND-Gatter (8), das an einem Eingang das verzögerte Signal (V) und an dem anderen Eingang das Ausgangssignal des Inverters (3) empfängt und das von der Zeitverschiebung ($\Delta t$) zwischen dem unverzögerten Signal (U) und dem verzögerten Signal (V) abhängige Meßsignal (M) abgibt, **dadurch gekennzeichnet, daß** der Inverter (3) ein steuerbarer Inverter ist, der durch ein Schaltsignal (I) zwischen einem invertierenden und einem nichtinvertierenden Zustand umschaltbar ist.

2. Schaltungsanordnung nach Anspruch 1, **dadurch gekennzeichnet**, das der steuerbare Inverter (3) aus einem XOR-Gatter (3) besteht, das an einem Eingang das Taktsignal (T) und an dem anderen Eingang das Schaltsignal (I) empfängt.

3. Schaltungsanordnung nach Anspruch 1 oder Anspruch 2, **dadurch gekennzeichnet, daß** das verzögerte Signal (V) aus dem Taktsignal durch ein zwischen den Eingang (1) der Schaltungsanordnung und den zweiten Ausgang (6) der Schaltungsanordnung eingefügtes Verzögerungselement (5) erzeugt wird.

4. Schaltungsanordnung nach Anspruch 3, **dadurch gekennzeichnet, daß** am Verzögerungselement (5) ein Sollwert ($\Delta t_s$) für die Verzögerungzeit durch ein Steuersignal (S) einstellbar ist.

5. Schaltungsanordnung nach einem der vorhergehenden Ansprüche, **dadurch gekennzeichnet, daß** eine Auswerteschaltung (9) vorgesehen ist, die aus dem vom NAND-Gatter (8) gelieferten Meßsignal (M) ein Signal (R) erzeugt, das der Zeitverschiebung ($\Delta t$) proportional ist, die zwischen dem unverzögerten Signal (U) und dem verzögerten Signal (V) besteht.

6. Schaltungsanordnung nach Anspruch 5, **dadurch gekennzeichnet, daß** das der Zeitverschiebung ($\Delta t$) proportionale Signal (R) dazu verwendet wird, das Verzögerungselement (5) so zu steuern, daß Abweichungen vom eingestellten Sollwert automatisch korrigiert werden.

**Claims**

1. A circuit arrangement for generating two signals (U, V) staggered in time from a clock signal (T) and for generating a measuring signal (M) which depends on the time stagger ($\Box t$) between the two signals (U, V), comprising an input (1) to which the clock signal (T) is applied, a first output (4) at which an undelayed signal (U) generated from the clock signal (T) is delivered, a second output (6) at which a signal (V) generated from the clock signal (T) and delayed relative to the undelayed signal (U) is delivered, an inverter (3) connected between the input (1) of the circuit arrangement and the first output (6) of the circuit arrangement, and a NAND gate (8) receiving at one input the delayed signal (V) and at the other input the output signal of the inverter (3) and providing the measuring signal (M) which depends on the time stagger ($\Box t$) between the undelayed signal (U) and the delayed signal (V), **characterized in that** the inverter (3) is a reversible inverter which can be switched by a switching signal (I) between an inverting condition and a non-inverting condition.

2. The circuit arrangement as set forth in claim 1, **characterized in that** the reversible inverter (3) consists of an XOR gate (3) receiving at one input the clock signal (T) and at the other input the switching signal (I).

3. The circuit arrangement as set forth in claim 1 or claim 2, **characterized in that** the delayed signal (V) is generated from the clock signal by a delay element (5) connected between the input (1) of the circuit arrangement and the second output (6) of the circuit arrangement.

4. The circuit arrangement as set forth in claim 3, **characterized in that** at the delay element (5) a setpoint value ($\Delta t_s$) for the delay time can be set by a control signal (S).

5. The circuit arrangement as set forth in any of the preceding claims, **characterized in that** an analyzer circuit (9) is provided which generates from the measuring signal (M) supplied by the NAND gate (8) a signal (R) which is proportional to the time stagger ($\Delta t$) existing between the undelayed signal (U) and the delayed signal (V).

6. The circuit arrangement as set forth in claim 5, **characterized in that** the signal (R) proportional to the time stagger ($\Delta t$) is used to control the delay element (5) such that departures from the set setpoint value are automatically corrected.

**Revendications**

1. Ensemble de circuits pour produire deux signaux opposés (U, V) décalés dans le temps à partir d'un signal d'horloge (T) et pour produire un signal de mesure (M) dépendant du décalage dans le temps ($\Delta$T) entre les deux signaux (U, V), comprenant une entrée (1) au niveau de laquelle le signal d'horloge (1) est appliqué, une première sortie (4) au niveau de laquelle est fourni un signal (U) à action instantanée produit à partir du signal d'horloge (T), une seconde sortie (6) au niveau de laquelle est fourni un signal (V) à action retardée, produit à partir du signal d'horloge (T) et opposé au signal (U) à action instantanée, un inverseur (3) placé entre l'entrée (1) de l'ensemble de circuits et la première sortie (4) de l'ensemble de circuits, et une porte NON-ET (8) qui, au niveau d'une entrée, reçoit le signal (V) à action retardée et, au niveau de l'autre entrée, reçoit le signal de sortie de l'inverseur (3), et qui fournit le signal de mesure (M) dépendant du décalage dans le temps ($\Delta$t) entre le signal (U) à action instantanée et le signal (V) à action retardée, **caractérisé en ce que** l'inverseur (3) est un inverseur réglable qui peut être inversé par un signal de commutation (I) entre un état d'inversion et de non-inversion.

2. Ensemble de circuits selon la revendication 1, **caractérisé en ce que** l'inverseur (3) réglable se compose d'une porte OU exclusif (3) qui, au niveau d'une entrée, reçoit le signal d'horloge (T) et, au niveau de l'autre entrée, reçoit le signal de commutation (I).

3. Ensemble de circuits selon la revendication 1 ou 2, **caractérisé en ce que** le signal (V) à action retardée est produit, à partir du signal d'horloge, par un élément (5) à action retardée placé entre l'entrée (1) de l'ensemble de circuits et la seconde sortie (6) de l'ensemble de circuits.

4. Ensemble de circuits selon la revendication 3, **caractérisé en ce qu'**une valeur nominale ($\Delta$t$_s$) définie pour le temps de retard et appliquée à l'élément (5) à action retardée est réglable par un signal de commande (S).

5. Ensemble de circuits selon l'une quelconque des revendications précédentes, **caractérisé en ce qu'**il est prévu un circuit de déclenchement (9) qui, à partir du signal de mesure (M) fourni par la porte NON-ET (8), produit un signal (R) qui est proportionnel au décalage dans le temps ($\Delta$t) existant entre le signal (U) à action instantanée et le signal (V) à action retardée.

6. Ensemble de circuits selon la revendication 5, **caractérisé en ce que** le signal (R) proportionnel au décalage dans le temps ($\Delta$t) est utilisé pour commander l'élément (5) à action retardée de façon telle, que des écarts par rapport à la valeur nominale réglée sont corrigés automatiquement.

**Fig. 1**

**Fig. 2**

| | **I** | **T** | **U** |
|---|---|---|---|
| NP | 0 | 0 | 0 |
| | 0 | 1 | 1 |
| MP | 1 | 0 | 1 |
| | 1 | 1 | 0 |

**Fig. 3**